(19) Europäisches Patentamt
European Patent Office
Office européen des brevets

(11) **EP 3 284 838 B1**

(12) **EUROPEAN PATENT SPECIFICATION**

(45) Date of publication and mention
of the grant of the patent:
**28.10.2020 Bulletin 2020/44**

(51) Int Cl.:
*C22C 19/00* *(2006.01)*     *C22C 19/03* *(2006.01)*
*C22C 19/05* *(2006.01)*

(21) Application number: **17186484.6**

(22) Date of filing: **16.08.2017**

(54) **FORMABLE SUPERALLOY SINGLE CRYSTAL COMPOSITION**

FORMBARE SUPERLEGIERUNGSEINKRISTALLZUSAMMENSETZUNG

COMPOSITION DE CRISTAL UNIQUE DE SUPERALLIAGE FORMABLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.08.2016 US 201615237976**

(43) Date of publication of application:
**21.02.2018 Bulletin 2018/08**

(73) Proprietor: **United Technologies Corporation
Farmington, CT 06032 (US)**

(72) Inventors:
• **SHAH, Dilip M.
Glastonbury, CT 06033 (US)**

• **CETEL, Alan D.
West Hartford, CT 06117 (US)**
• **SEETHARAMAN, Venkatarama K.
Rocky Hill, CT 06067 (US)**

(74) Representative: **Dehns
St. Bride's House
10 Salisbury Square
London EC4Y 8JD (GB)**

(56) References cited:
**EP-A1- 0 248 757       GB-A- 2 462 704
US-A- 4 574 015        US-A- 5 900 084
US-A1- 2015 284 824    US-B2- 7 115 175**

## Description

## BACKGROUND

The present disclosure relates to a formable superalloy single crystal composition.

Gas turbine aero engines and industrial gas turbine (IGT) turbine blades are subjected to high metal temperatures. In the earliest generation, these blades were manufactured of Waspaloy® or similar alloys, a first generation of precipitation hardened nickel base superalloys containing only 25-30 volume % of hard $Ni_3(Al,X)$ precipitates. Such alloys were forgeable and had sufficiently high ductility. Subsequently, castable nickel base superalloys were introduced with higher Al+X content with volume fraction of precipitates increased to 60-65% to achieve optimum creep resistance. In spite of lower ductility, these conventionally cast superalloys proved attractive as it allowed blades to be cast hollow compared to solid forged blades and enabled air cooling of the blades, thereby allowing operation in higher gas path air.

It was then realized that in both forged and cast alloys, presence of grain boundaries reduced the intrinsic creep capability of the material. As a result, a directional solidification process was developed, whereby a columnar grain structure was achieved parallel to the blade axis, which is the principal loading direction as it is a rotating component. With no grain boundaries normal to the principal stress, creep resistance of the alloy was significantly improved. Nonetheless, owing to the presence of grain boundaries, the alloys required so called grain boundary strengthening elements such as C, B, Zr and Hf, which lowered the incipient (local) melting point of the alloys and inhibited advanced alloy development to further improve creep resistance.

To further improve the creep resistance and realize the full potential improvement in creep resistance with addition of refractory elements such as Ta and Re, the directional solidification process was modified such that only one columnar grain or single crystal was allowed to form the entire blade. The complete elimination of grain boundaries allowed minimizing the melting point depressing minor elements C, B, Zr and Hf and facilitated achieving full benefit of refractory elements. All through this development process, however, precipitate volume fraction of 60-65% was preserved as being optimum for improving the creep resistance at 1800°F or higher.

The development history of superalloys over last 40-50 years was primarily focused on turbine blades as being the hottest component in the engine. Eventually the single crystal technology was used for other components in the gas path such as vanes, blade outer air seals, and combustor panels. Some of the technology applied to the next hottest running components such as side plates and turbine discs, but these components are still made out of alloys similar to conventionally cast alloys used for first generation blades, albeit with much finer grain structure achieved by either powder metallurgical approach or by hot working the material. Similarly other peripheral components such "W-seals" are manufactured of Waspaloy® sheet metals - the earliest generation of superalloy with high ductility and good formability.

As the temperature capability of single crystal turbine blades is enhanced, with advanced alloying, advanced cooling schemes, and thermal barrier coatings, the temperature capability of the disk, side plates, and other peripheral components such as "W-seal" in the engine, must also be increased proportionally. This follows the evolutionary path of single crystal technology to other gas path components, but with several significant differences.

Increased temperature requirements for disc, side plates and other peripheral components such as "W-seal," and eventually engine cases, is somewhat different compared to components in the gas path, in that these components currently operate, typically below 1400°F, and temperature capability is expected to rise to no more than 1700°F, as long as blades are made of single crystal superalloys. Also, many of these components are larger in dimension (disc, side plates, cases) compared to blades, or require a long strip of sheet metal (W-seal), or require forging (discs and side plates) or extensive welding (cases) or bending (W-seal), processes. Nonetheless, from the standpoint of alloy creep-capability, it is clear that ultimately elimination of grain boundaries or single crystal structure will be required to enhance the temperature performance of these components. But at the same time given the shape and size and other requirements, it may not be possible to escape bend forming, forging and welding processes for these components.

US2015/0284824 discloses a nickel-based alloy having a microstructure with a matrix of γ-phase and precipitates of γ'-phase. The nickel-based alloy comprises 8 to 13 at.% aluminum, 3 to 14 at.% cobalt, 4 to 12 at.% chromium, 0.6 to 8 at.% molybdenum, 0 to 6 at.% rhenium, 0.5 to 4 at.% tantalum, 0.5 to 4 at.% titanium, 0.3 to 3.5 at.% tungsten, 0 to 4 at.% germanium, 0 to 0.6 at.% hafnium, 0 to 4 at.% ruthenium, balance nickel and unavoidable impurities.

## SUMMARY

A formable nickel based superalloy composition (e.g. for a gas turbine blade) according to the present disclosure consists of a two phase γ/γ' precipitation hardenable nickel base superalloy consisting of 69.35 at.% Ni, 5.15 at.% Co, 11.68 at.% Cr, 1.32 at.% W, 2.93 at.% Ta, 1.38 at.% Ti and 8.19 at.% Al, cast in form of a single crystal.

The foregoing features and elements as well as the operation thereof will become more apparent in light of the following description and the accompanying drawings. It should be understood, however, the following description and drawings are intended to be exemplary in nature and non-limiting.

**BRIEF DESCRIPTION OF THE DRAWINGS**

Various features will become apparent to those skilled in the art from the following detailed description of the disclosed non-limiting embodiment. The drawings that accompany the detailed description can be briefly described as follows:

Figure 1 is a schematic cross-section of an example gas turbine engine architecture;
Figure 2 is a schematic cross-section of another example gas turbine engine architecture;
Figure 3 is an enlarged schematic cross-section of an engine high pressure turbine section;
Figure 4 is a schematic representation of superalloy microstructure with different shape and volume percentage of $\gamma'$ precipitates;
Figure 5 is variation in minimum and maximum free distance in $\gamma$-matrix with volume fraction of $\gamma'$ precipitates;
Figure 6 is variation in relative tensile strength with volume fraction of $\gamma'$ precipitates;
Figure 7 is relation between creep rupture life and volume fraction of $\gamma'$ precipitates;
Figure 8 is flow chart showing development of advanced formable nickel base superalloy compositions; and
Figure 9 is a table showing a representative alloy with a reduced volume fraction of $\gamma'$ precipitates.

**DETAILED DESCRIPTION**

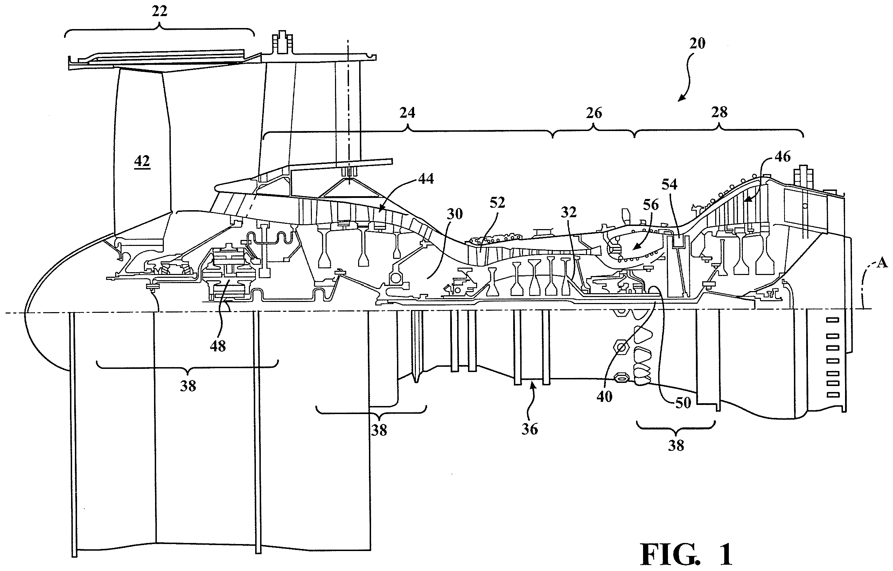

Figure 1 schematically illustrates a gas turbine engine 20. The gas turbine engine 20 is disclosed herein as a two-spool turbofan that generally incorporates a fan section 22, a compressor section 24, a combustor section 26, and a turbine section 28. Alternative engine architectures will also benefit herefrom. The fan section 22 drives air along a bypass flowpath while the compressor section 24 drives air along a core flowpath for compression and communication into the combustor section 26, then expansion through the turbine section 28. Although depicted as a turbofan in the disclosed non-limiting embodiment, it should be understood that the concepts described herein are not limited to use with turbofans and may be applied to other types of turbine engine architectures such as turbojets, turboshafts, and three-spool (plus fan) turbofans.

The engine 20 generally includes a low spool 30 and a high spool 32 mounted for rotation about an engine central longitudinal axis A relative to an engine static structure 36 via several bearing compartments 38. The low spool 30 generally includes an inner shaft 40 that interconnects a fan 42, a low pressure compressor ("LPC") 44, and a low pressure turbine ("LPT") 46. The inner shaft 40 drives the fan 42 directly, or through a geared architecture 48, to drive the fan 42 at a lower speed than the low spool 30. An exemplary reduction transmission is an epicyclic transmission, namely a planetary or star gear system.

The high spool 32 includes an outer shaft 50 that interconnects a high pressure compressor ("HPC") 52 and high pressure turbine ("HPT") 54. A combustor 56 is arranged between the high pressure compressor 52 and the high pressure turbine 54. The inner shaft 40 and the outer shaft 50 are concentric and rotate about the engine central longitudinal axis A.

Core airflow is compressed by the LPC 44, then the HPC 52, mixed with fuel and burned in the combustor 56, then expanded over the HPT 54 and the LPT 46. The HPT and LPT 54, 46 rotationally drive the respective low spool 30 and high spool 32 in response to the expansion.

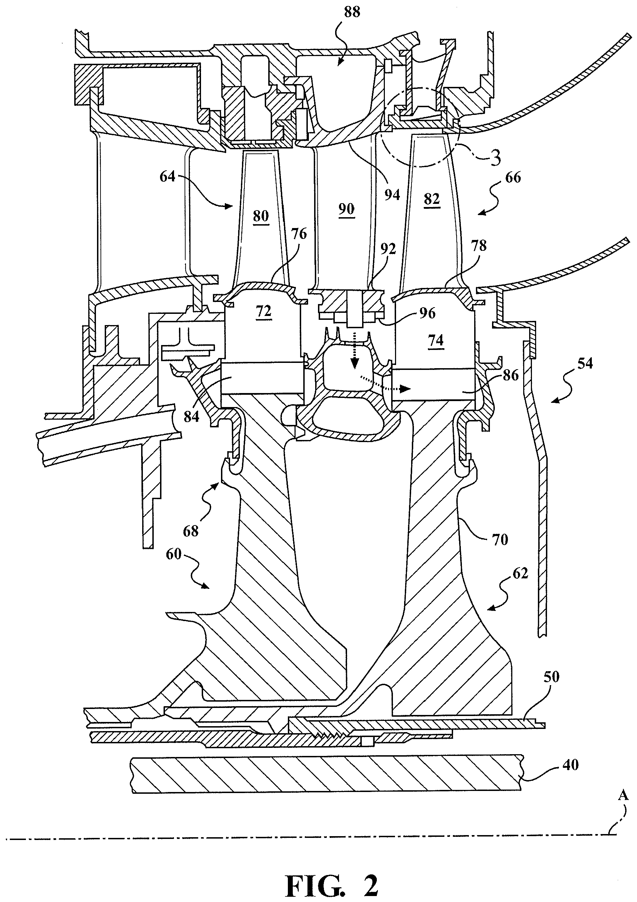

With reference to Figure 2, an enlarged schematic view of the HPT 54 is shown by way of example; however, other engine sections will also benefit herefrom. The HPT 54 includes a two-stage turbine section with a first rotor assembly 60 and a second rotor assembly 62, both of which are affixed to the outer shaft 50.

The rotor assemblies 60, 62 include a respective array of blades 64, 66 circumferentially disposed around a disk 68, 70. Each blade 64, 66 include a respective root 72, 74, a platform 76, 78 and an airfoil 80, 82. Each blade root 72, 74 is received within a respective rim 84, 86 of the disk 68, 70 and the airfoils 80, 82 extend radially outward toward a blade outer air seal (BOAS) assembly 81, 83.

The blades 64, 66 are disposed in the core flowpath that is pressurized in the compressor section 24 then heated to a working temperature in the combustor section 26. The platforms 76, 78 separate a gas path side inclusive of the airfoil 80, 82 and a non-gas path side inclusive of the root 72, 74.

A shroud assembly 88 within the engine case structure 36 between the blade stages 26, 28 directs the hot gas core airflow in the core flowpath from the first stage blades 64 to the second stage blades 66. The shroud assembly 88 may at least partially support the BOAS assemblies 81, 83 and includes an array of vanes 90 that extend between a respective inner vane platform 92 and an outer vane platform 94. The outer vane platforms 94 may be supported by the engine case structure 36 and the inner vane platforms 92 support an abradable annular seal 96 to seal the hot gas core airflow.

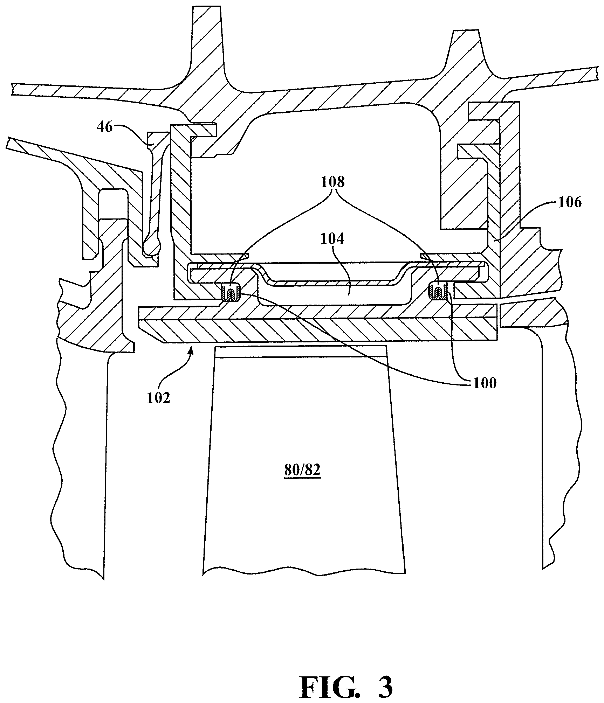

With reference to Figure 3, example formed components such as W-seals 100 are located throughout engine 10. Located radially inward from the engine case, and radially outward from the blade 80, 82 are the W-seals 100 and shroud assembly 102. The shroud assembly 102 generally includes BOAS 104, BOAS supports 106, and various other seals (removed for clarity). Cooperating hooks mount the BOAS 104 and BOAS supports 106. Cavities 108 are formed between BOAS 104 and BOAS support 106. The W-seals 100 are contained within the respective cavity 108 to prevent air leakage between the components of shroud assembly 102 to restrict mass flow of air between BOAS 104 and BOAS support 106.

The example W-seals 100 are manufactured of a precipitation hardened formable superalloy single crystal composition. It should be appreciated that various seals and other applications that are to be bent or otherwise hot worked or formed from a relatively flat material will also, benefit herefrom.

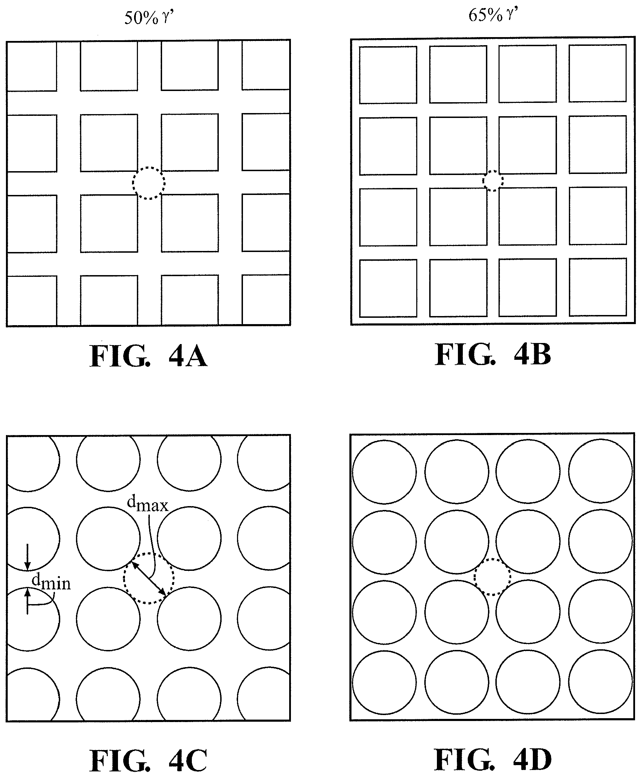

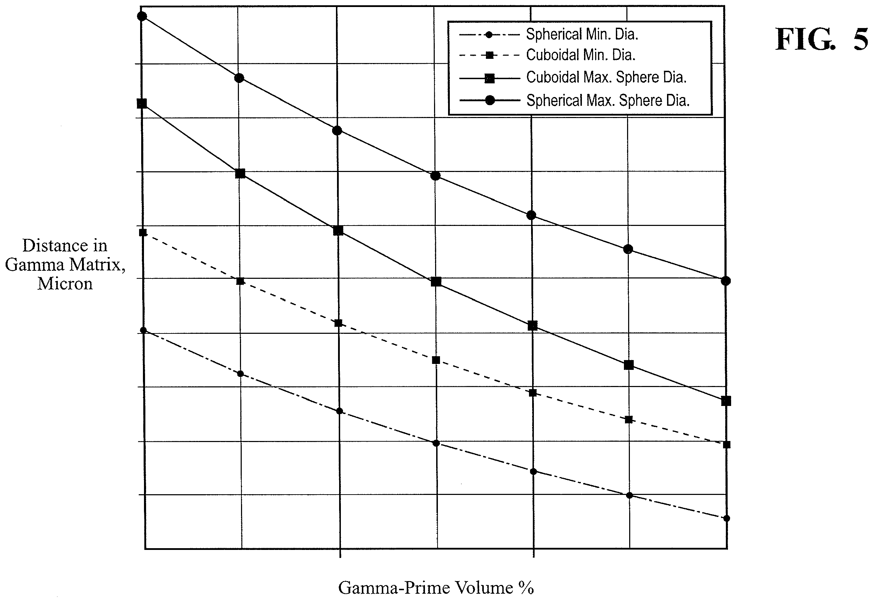

With reference to Figures 4A-4D, an idealized and uniform microstructure of a typical precipitation hardened superalloy are schematically shown. The microstructure is depicted at 50 and 65 volume % of the precipitates, in either cuboidal or spheroidal shape. The cuboidal and spheroidal islands are the hard $\gamma'$ precipitate phase, whereas the remaining area is referred to as the $\gamma$-matrix, typically a more ductile and softer deformable solid solution phase. All cases are depicted with identical precipitate size. The size of $\gamma$-matrix channels are categorized by either minimum distance between the precipitates, $d_{min}$ or maximum distance between the precipitates, $d_{max}$ decreases as the volume fraction of $\gamma'$ increases from 50% to 65%. This is also shown graphically in Figure 5, where these parameters are plotted against the volume fraction of the precipitates.

Tensile Strength and Ductility

When the material is plastically deformed at high stress, much of the deformation occurs by motion of line defects called dislocations within the $\gamma$-matrix. There are many complex metallurgical models to relate strength to the precipitate size and size of the $\gamma$-matrix channels, but in its most simple form, an Orowan hardening theory states that the shear stress $\tau$ is related to the $\gamma$-matrix channel by equation 1

$$\tau \propto Gb/\lambda \quad \text{[equation 1]}$$

Where G is shear modulus of the material, b is called Burgers vector characteristic measure of the dislocation line defect and $\lambda$ is the mean free distance such line defects can move and multiply in the $\gamma$-matrix channel measured by either $d_{min}$ or $d_{max}$.

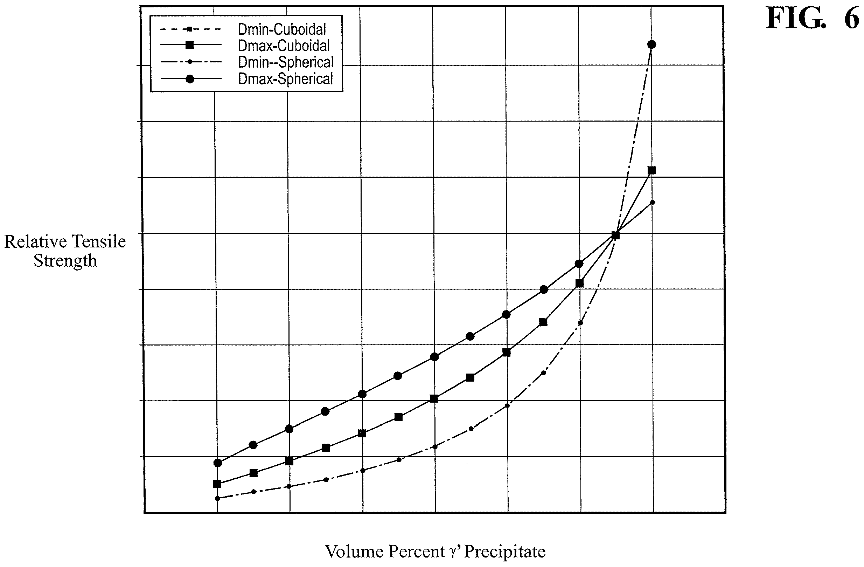

Based on this simple model relative tensile strength of this class of alloys with varying volume fraction of precipitates is plotted in Figure 6. Tensile strength is considered proportional to the shear strength. Here, for the comparison purposes it is assumed that tensile strength is 100% at the current typical 65 volume % of precipitates.

Based on this model the tensile strength is expected to decrease by 28% if the volume % of the precipitates is decreased from 65 to 50%. Metallurgically, a decrease in strength is typically accompanied by increase in ductility, which is considered favorable for any bending or cold or hot wrought process. Thus a material with 50 volume % precipitate is relatively more formable than a material with 65 volume % precipitate. Once the material is worked - or plastically deformed - it work hardens and the strength increases. However, material with lower volume fraction of the precipitates is likely to soften faster and easier upon annealing heat treatments, than the material with higher volume fraction of the precipitates.

Creep Resistance

Creep deformation is material deforming under a sustained low stress at high temperatures. While tensile strength and ductility can be approximately correlated to the geometrical nature of the precipitate structure, high temperature creep resistance or time dependent deformation of the material is critically governed by (a) alloy chemistry and (b) presence or absence of high diffusion paths like grain boundaries. The geometry of the precipitate structure plays a secondary role. The alloy chemistry controls the diffusion or movement of elements primarily within the $\gamma$-matrix. Rapid movement of these elements let the dislocation line defect move by a process called climb and let the material plastically deform at high temperatures even if the stress is below its tensile strength. If the alloying elements added to the alloy are higher melting or so called refractory elements such as Mo, W, Ru and Re, less they move and more creep resistant is the material. These elements cannot be added indiscriminately or else the $\gamma$-matrix becomes unstable to what is called topologically closed packed (TCP) phases with exposure at high temperatures and loses its creep resistance. A simple calculation based on electron vacancy number $N_v$ provides an approximate guidance but most alloy developer rely on their own proprietary model and experiments. In summary, a single crystal with no grain boundaries to provide rapid diffusion paths, and with high level of refractory elements with sluggish movements, display the most creep resistance.

The process of climb of dislocations to by-pass the hard $\gamma'$ precipitates, takes a relatively longer time with respect to the relative increase in the precipitate size, but, this occurs only up to a point. At a given volume %, if the precipitates are too large then the $\gamma$-matrix channel becomes wider and dislocations can escape without climbing over the precipitates and creep resistance deteriorates.

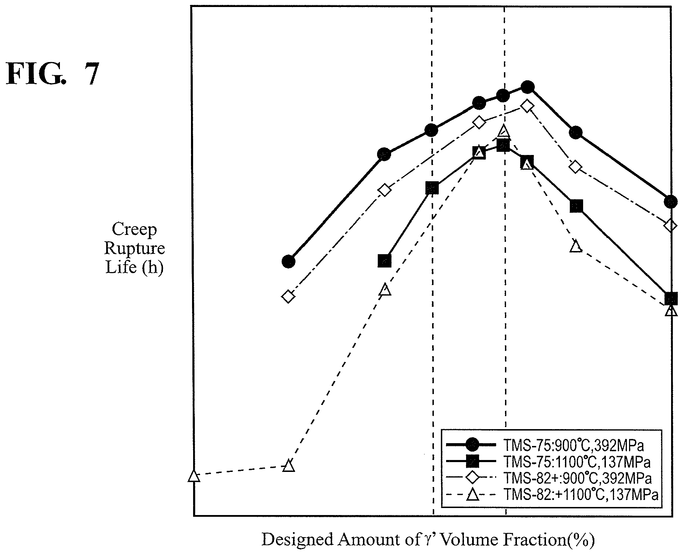

However complicated these mechanistic explanations maybe, the results of an empirical study as shown in Figure 7 shows that creep rupture life at 900°C(1652°F) decreases by ~3X when the volume fraction of $\gamma'$ precipitates is reduced from 65% to 50%. For most nickel base superalloys this translates into ~50°F loss in temperature capability. This can be straightforwardly surmised from the following Larson-Miller parameter used for typical single crystal alloys to swap time and temperature for creep deformation.

Typical Larson-Miller Parameter = (T+460)[C+ log(t)], where C is typically 18-21 depending on the alloy chemistry. Assuming C=18, it is easy to show that for the alloys shown in Figure 7, if the alloy with 50 volume % precipitate with rupture life of ~300 hours at 900°C (1652°F)/392 MPa (58.55 Ksi), were to have ~1000 hour of rupture life equivalent to an alloy with 65 volume % precipitate, the temperature will have to drop to 870.6°C (1599°F). If the calculation were based on C=21, the temperature is projected to drop to 873.9°C (1605°F).

This loss of ~50°F temperature capability is not unacceptable when a current single crystal alloy is ~200°F better than the material it is expected replace such as Wapaloy® for W-seal applications. Furthermore for certain other applications, improved formability and weldability along with improved TMF performance associated with low modulus <100> orientation may outweigh the lesser increase in temperature capability. It should be appreciated that [100], [010], [001], [111] are vectors describing different crystallographic directions and one step or one cube edge along X-axis is [100], one cube edge along Y-axis is [010] ......... and if one goes 1 step along X, 1 step along Y and 1 step along Z direction along the body diagonal then it is [111]. Owing to symmetry really [100], [010], [001] are all same and are generally referred to with carrot brackets as <100>, which implies a family of similar directions. Similarly <111> implies all four specific variants [111], [-1,1,1], [1,-1,1], [1,1,-1], A plane normal to [100] vector is designated by round bracket as (100) plane. A family of all (100), (010) and (001) planes are designated by {} brackets as {100}. Low modulus <100> direction is most useful in improving strain controlled TMF life as shown in next two slides. In some cases, low modulus is known to help prevent RX. Somewhat high modulus <110> direction helps avoid vibratory modes in airfoil for <100> blades. High modulus <111> direction is useful in high vibratory environment.

It should also be appreciated the creep requirements for different components are highly design dependent. For example, in design of a disk, one is only interested in time to a fixed % strain rather than the creep rupture life. All these aspects are not specifically captured by the above arguments based on a Larson-Miller parametric analysis typically used for turbine blade design. Creep in cast alloys show high primary creep, which is suppressed when the material is pre-strained either by cold or hot worked, improving time to say 0.1% or 0.2% strain.

Optimum precipitate volume % for many of the non-gas path and peripheral components lies below 60% for single crystal application with improved formability and weldability with definite temperature and low and high Young's modulus advantage over polycrystalline material. Experience has shown that counter to conventional understanding, removal of grain boundaries in single crystal facilitates the rolling process as grain-to-grain incompatible deformation is absent. Experience further shows that again counter to conventional understanding, recovery process is slower in single crystal allowing strength gained through work hardening to be retained to higher temperatures. Also, recrystallization is not a major issue for most of the non-gas path and peripheral components exposed to temperatures below 2000°F in service.

Implementation

More formable and weldable single crystal alloy compositions are possible if the precipitate volume fraction were decreased to the range of 40-55%. This will allow one to process these single crystal alloys with greater ease and fewer steps at only marginal loss of tis creep capability and oxidation resistance required at somewhat lower temperature range of 1500-1700°F compared to blade application of 1800-2000°F.

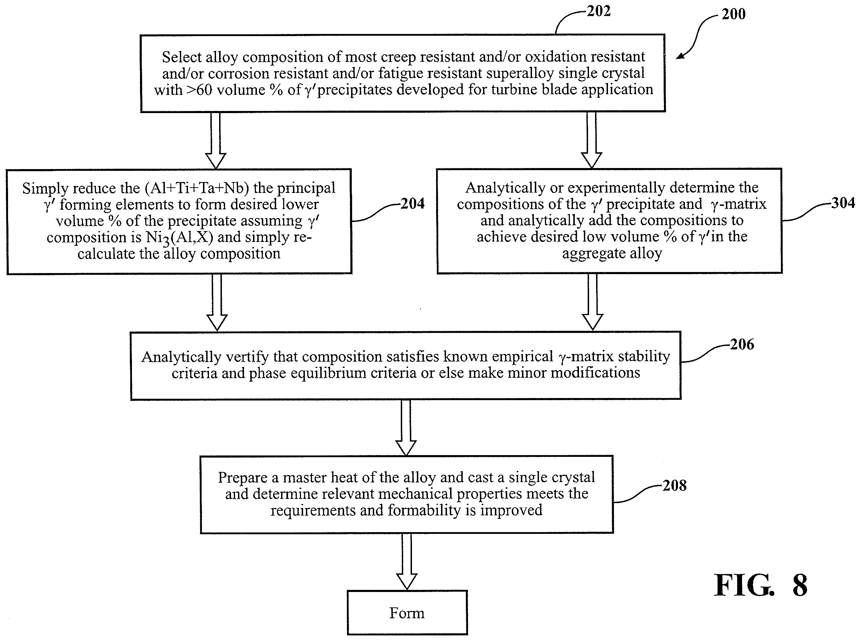

An optimum superalloy composition with < 65 volume % $\gamma'$ precipitates, and cast as a single crystal with a known investment casting technique using directional solidification is outlined in the process 200 represented in the flow chart of Figure 8. A well-developed single crystal alloy such as PWA 1480 is selected depending on other engineering and economic considerations (step 202). For example PWA 1480 is preferred if expensive element like Re is to be avoided.

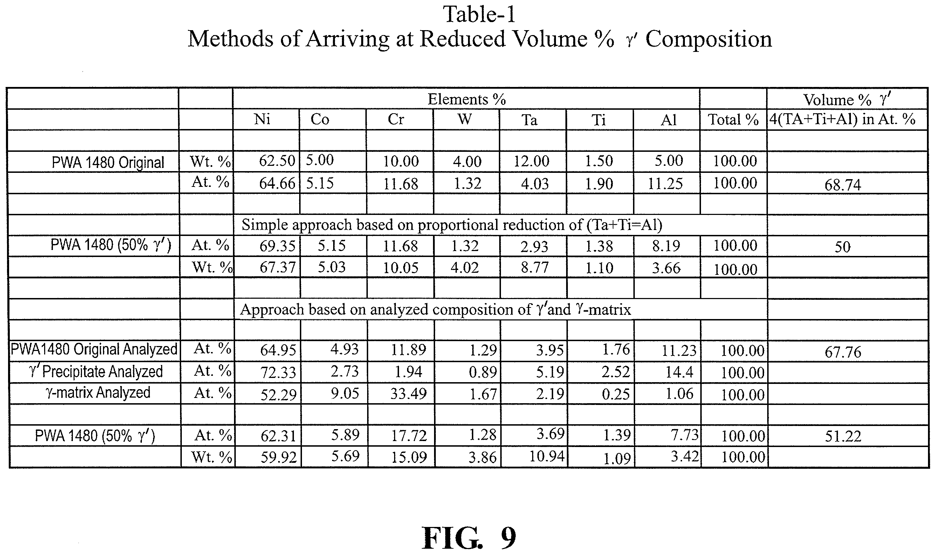

Once a single crystal alloy is selected (step 202), the simplest approach is to convert the composition from weight % to atom % of the element as illustrated in Table-1 (Figure 9) for PWA 1480 (step 204). Then the sum of $\gamma'$ forming elements (Ta+Ti+Al) is proportionally reduced to form 50 volume % of the precipitate (step 206). Ignoring other elements that partition to $\gamma'$, the volume % can be estimated as 4(Ta+Ti+Al) in atom %. The reduction is then compensated by increase in Ni content, while keeping the rest of the element at the same level.

Alternatively, the composition of $\gamma'$ and $\gamma$-matrix are either determined experimentally or may be calculated based on a well-developed model (step 304). Such well-developed models could be commercially available software systems such as Thermo-Calc developed by Thermo-Calc Software Inc. In Table-1 experimentally determined values are used. Based on these values aggregate alloy composition for 50 volume % of the precipitate is calculated and composition converted to weight % for practical use. This approach retains the most optimized $\gamma$-matrix composition for best creep performance.

Next, the composition is analytically verified to satisfied known empirical $\gamma$-matrix stability criteria and phase equilibrium criteria or else make minor modifications (step 206). Finally, a master heat of the alloy is prepared and cast a single crystal and determines relevant mechanical properties meets the requirements and formability is improved.

The methods may be practiced with greater ease with 40-55% volume % of the precipitates. While such alloys may not be optimized for blade application, they may prove useful for disk, side plate, cases, seals and many other component applications. For such components, the single crystal character facilitates the temperature capability of the material by enhancing creep resistance, provide improved compliance and TMF capability with lower modulus in direction, or higher stiffness in direction if required to reduce deflection, increase critical speed of shafts or HCF life in vibratory environment, while providing the added advantage of formability and weldability.

The use of the terms "a," "an," "the," and similar references in the context of description (especially in the context of the following claim) are to be construed to cover both the singular and the plural, unless otherwise indicated herein or specifically contradicted by context. The modifier "about" used in connection with a quantity is inclusive of the stated value and has the meaning dictated by the context (e.g., it includes the degree of error associated with measurement of the particular quantity). All ranges disclosed herein are inclusive of the endpoints, and the endpoints are independently combinable with each other.

Although the different non-limiting embodiments have specific illustrated components, the embodiments of this invention are not limited to those particular combinations. It is possible to use some of the components or features from any of the non-limiting embodiments in combination with features or components from any of the other non-limiting embodiments.

It should be appreciated that like reference numerals identify corresponding or similar elements throughout the several drawings. It should also be appreciated that although a particular component arrangement is disclosed in the illustrated embodiment, other arrangements will benefit herefrom.

Although particular step sequences are shown, described, and claimed, it should be understood that steps may be performed in any order, separated or combined unless otherwise indicated and will still benefit from the present disclosure.

The foregoing description is exemplary rather than defined by the limitations within. Various non-limiting embodiments are disclosed herein. The appended claim should be studied to determine its true scope and content.

More formable and weldable single crystal alloy compositions are possible if the precipitate volume fraction were decreased to the range of 40-55%. This will allow one to process these single crystal alloys with greater ease and fewer steps at only marginal loss of tis creep capability and oxidation resistance required at somewhat lower temperature range of 1500-1700°F compared to blade application of 1800-2000°F.

An optimum superalloy composition with < 65 volume % γ' precipitates, and cast as a single crystal with a known investment casting technique using directional solidification is outlined in the process 200 represented in the flow chart of Figure 8. A well-developed single crystal alloy such as PWA 1480, PWA 1483 or PWA 1484 (or a low sulfur version PWA 1429) is selected depending on other engineering and economic considerations (step 202). For example PWA 1480 and PWA 1483 are preferred if expensive element like Re is to be avoided. Among these two alloys, PWA 1483 with higher Cr content may be preferred if hot corrosion is a major concern. For highest temperature performance, PWA 1484 is preferred.

Once a single crystal alloy is selected (step 202), the simplest approach is to convert the composition from weight % to atom % of the element as illustrated in Table-1 (Figure 9) for PWA 1480 (step 204). Then the sum of γ' forming elements (Ta+Ti+Al) is proportionally reduced to form 50 volume % of the precipitate (step 206). Ignoring other elements that partition to γ', the volume % can be estimated as 4(Ta+Ti+Al) in atom %. The reduction is then compensated by increase in Ni content, while keeping the rest of the element at the same level.

Alternatively, the composition of γ' and γ-matrix are either determined experimentally or may be calculated based on a well-developed model (step 304). Such well-developed models could be commercially available software systems such as Thermo-Calc developed by Thermo-Calc Software Inc. In Table-1 experimentally determined values are used. Based on these values aggregate alloy composition for 50 volume % of the precipitate is calculated and composition converted to weight % for practical use. This approach retains the most optimized γ-matrix composition for best creep performance.

Next, the composition is analytically verified to satisfied known empirical γ-matrix stability criteria and phase equilibrium criteria or else make minor modifications (step 206). Finally, a master heat of the alloy is prepared and cast a single crystal and determines relevant mechanical properties meets the requirements and formability is improved.

The disclosed embodiments lead to compositions differing primarily in the Cr content. This is so because Cr primarily partitions to γ-matrix. It should be appreciated that thermodynamic equilibrium of the elements changes once the volume % of the precipitates is changed but the approaches provide a reasonable starting point for a derivative alloy composition of an alloy with considerable processing and usage experience.

Attempts to arrive at such derivative compositions at various volume % γ' is presented in Table-2 (Figure 10) along with predicted creep performance. It is anticipated that adjustment of the composition will be required for final application to achieve balance of engineering properties.

The present method details that the methods may be practiced with greater ease with 40-55% volume % of the precipitates. While such alloys may not be optimized for blade application, they may prove useful for disk, side plate, cases, seals and many other component applications. For such components, the single crystal character facilitates the temperature capability of the material by enhancing creep resistance, provide improved compliance and TMF capability with lower modulus in direction, or higher stiffness in direction if required to reduce deflection, increase critical speed of shafts or HCF life in vibratory environment, while providing the added advantage of formability and weldability.

The use of the terms "a," "an," "the," and similar references in the context of description (especially in the context of the following claims) are to be construed to cover both the singular and the plural, unless otherwise indicated herein or specifically contradicted by context. The modifier "about" used in connection with a quantity is inclusive of the stated value and has the meaning dictated by the context (e.g., it includes the degree of error associated with measurement of the particular quantity). All ranges disclosed herein are inclusive of the endpoints, and the endpoints are independently combinable with each other.

Although the different non-limiting embodiments have specific illustrated components, the embodiments of this invention are not limited to those particular combinations. It is possible to use some of the components or features from any of the non-limiting embodiments in combination with features or components from any of the other non-limiting embodiments.

It should be appreciated that like reference numerals identify corresponding or similar elements throughout the several drawings. It should also be appreciated that although a particular component arrangement is disclosed in the illustrated embodiment, other arrangements will benefit herefrom.

Although particular step sequences are shown, described, and claimed, it should be understood that steps may be performed in any order, separated or combined unless otherwise indicated and will still benefit from the present disclosure.

Preferred embodiments of the present disclosure are as follows:

1. A formable nickel based superalloy composition, comprising:
a two phase $\gamma/\gamma'$ precipitation hardenable nickel base superalloy with a sum of primarily $\gamma'$ forming elements in atom % in the range of about 10-16, forming about a 40-64 volume % of the $\gamma'$ precipitate, cast in form of a single crystal.

2. The composition as recited in embodiment 1, wherein the $\gamma'$ forming elements are Nb+Ta+Ti+Al.

3. The composition as recited in embodiment 1, wherein the type $\gamma'$ precipitate are Ni3(Al,X).

4. The composition as recited in embodiment 1, wherein the $\gamma'$ forming elements are Nb+Ta+Ti+Al and the type $\gamma'$ precipitate are Ni3(Al,X).

5. The composition as recited in embodiment 1, wherein the two phase $\gamma/\gamma'$ precipitation hardenable nickel base superalloy is formed as a thin sheet metal.

6. The composition as recited in embodiment 1, wherein the two phase $\gamma/\gamma'$ precipitation hardenable nickel base superalloy is procured from a single crystal body.

7. The composition as recited in embodiment 1, further comprising subjecting the two phase $\gamma/\gamma'$ precipitation hardenable nickel base superalloy to a wrought process that imparts more than 0.1 % plastic strain to achieve the final shape.

8. The composition as recited in embodiment 1, further comprising subjecting the two phase $\gamma/\gamma'$ precipitation hardenable nickel base superalloy to a hot wrought process.

9. The composition as recited in embodiment 1, further comprising subjecting the two phase $\gamma/\gamma'$ precipitation hardenable nickel base superalloy to a cold wrought process.

10. The composition as recited in embodiment 1, further comprising subjecting the two phase $\gamma/\gamma'$ precipitation hardenable nickel base superalloy to at least one wrought process such as bending, rolling, forging, swaging, and extrusion,

11. The composition as recited in embodiment 1, further comprising subjecting the two phase $\gamma/\gamma'$ precipitation hardenable nickel base superalloy to at least one of a welding, brazing, transient phase liquid (TLP) bonding, inertial bonding, and friction welding process.

12. The composition as recited in embodiment 1, wherein the two phase $\gamma/\gamma'$ precipitation hardenable nickel base superalloy is derived from an existing nickel base superalloy, polycrystalline or single crystal alloy, with > 60 volume % of $\gamma'$ precipitate, using a simpler to more complex thermodynamic modeling software.

13. The composition as recited in embodiment 1, wherein the two phase $\gamma/\gamma'$ precipitation hardenable nickel base superalloy is derived from an PWA 1480, PWA 1483, PWA 1484, PWA 1429, PWA 1430, and PWA 1497 single crystal alloy composition.

14. A method of manufacturing a formable nickel based superalloy composition, comprising:

selecting an alloy composition with a superalloy single crystal with >60 volume % of phase $\gamma'$ precipitates;
reducing the principal $\gamma'$ forming elements to form desired lower volume % of the precipitate assuming $\gamma'$ composition;
verifying that composition satisfies known em-

pirical $\gamma'$ - matrix stability criteria and phase equilibrium criteria; and

preparing a master heat of the alloy and cast a single crystal to determine relevant mechanical properties for a formability process.

15. The method as recited in embodiment 14, wherein reducing the principal $\gamma'$ forming elements comprises reducing the (Al+Ti+Ta+Nb) the principal $\gamma'$ forming elements to form desired lower volume % of the precipitate assuming ' composition is Ni3(Al,X).

16. The method as recited in embodiment 14, wherein reducing the principal $\gamma'$ forming elements comprises analytically determining the compositions of the $\gamma'$ precipitate and $\gamma$-matrix and analytically adding the compositions to achieve desired low volume % of $\gamma'$ in the aggregate alloy.

17. The method as recited in embodiment 14, wherein selecting an alloy composition includes selecting a phase $\gamma'$ precipitates developed for turbine blade applications.

18. The method as recited in embodiment 14, further comprising using the two phase $\gamma/\gamma'$ precipitation hardenable nickel base superalloy in a crystallographic direction to suppress recrystallization during a forming operation.

19. The method as recited in embodiment 14, further comprising using the two phase $\gamma/\gamma'$ precipitation hardenable nickel base superalloy in a crystallographic direction to provide a desired grain texture upon forming.

20. The method as recited in embodiment 14, further comprising using the two phase $\gamma/\gamma'$ precipitation hardenable nickel base superalloy for a low modulus, high compliance application exploiting a low modulus crystallographic direction or a high modulus, high stiffness application, exploiting its high modulus crystallographic direction.

The foregoing description is exemplary rather than defined by the limitations within. Various non-limiting embodiments are disclosed herein, however, one of ordinary skill in the art would recognize that various modifications and variations in light of the above teachings will fall within the scope of the appended claims. It is therefore to be understood that within the scope of the appended claims, the disclosure may be practiced other than as specifically described. For that reason the appended claims should be studied to determine true scope and content.

## Claims

1. A formable nickel based superalloy composition, consisting of:
a two phase $\gamma/\gamma'$ precipitation hardenable nickel base superalloy consisting of 69.35 at.% Ni, 5.15 at.% Co, 11.68 at.% Cr, 1.32 at.% W, 2.93 at.% Ta, 1.38 at.% Ti and 8.19 at.% Al, cast in the form of a single crystal.

## Patentansprüche

1. Formbare Nickelbasis-Superlegierungszusammensetzung, bestehend aus:
einer zweiphasigen $\gamma/\gamma'$-ausscheidungshärtbaren Nickelbasis-Superlegierung, die aus 69,35 At.-% Ni, 5,15 At.-% Co, 11,68 At.-% Cr, 1,32 At.-% W, 2,93 At.-% Ta, 1,38 At.-% Ti und 8,19 At.-% Al besteht, die in der Form eines Einkristalls gegossen ist.

## Revendications

1. Composition de superalliage à base de nickel formable, comprenant :
un superalliage à base de nickel durcissable par précipitation en deux phases $\gamma/\gamma'$, composé de 69,35 % atomique de Ni, 5,15 % atomique de Co, 11,68 % atomique de Cr, 1,32 % atomique de W, 2,93 % atomique de Ta, 1,38 % atomique de Ti et 8,19 % atomique de Al, coulé sous la forme d'un monocristal.

**FIG. 1**

**FIG. 2**

**FIG. 3**

50% γ'

65% γ'

## FIG. 4A

## FIG. 4B

$d_{max}$

$d_{min}$

## FIG. 4C

## FIG. 4D

FIG. 5

FIG. 6

Legend:
- Dmin-Cuboidal
- Dmax-Cuboidal
- Dmin-Spherical
- Dmax-Spherical

Relative Tensile Strength

Volume Percent γ' Precipitate

# FIG. 7

Creep Rupture Life (h)

Designed Amount of γ' Volume Fraction(%)

Legend:
- ●——— TMS-75:900°C,392MPa
- ■——— TMS-75:1100°C,137MPa
- ◇—·—· TMS-82+:900°C,392MPa
- △----- TMS-82+:1100°C,137MPa

EP 3 284 838 B1

Select alloy composition of most creep resistant and/or oxidation resistant and/or corrosion resistant and/or fatigue resistant superalloy single crystal with >60 volume % of γ′ precipitates developed for turbine blade application

— 202

200

Simply reduce the (Al+Ti+Ta+Nb) the principal γ′ forming elements to form desired lower volume % of the precipitate assuming γ′ composition is Ni₃(Al,X) and simply re-calculate the alloy composition

— 204

Analytically or experimentally determine the compositions of the γ′ precipitate and γ-matrix and analytically add the compositions to achieve desired low volume % of γ′ in the aggregate alloy

— 304

Analytically vertify that composition satisfies known empirical γ-matrix stability criteria and phase equilibrium criteria or else make minor modifications

— 206

Prepare a master heat of the alloy and cast a single crystal and determine relevant mechanical properties meets the requirements and formability is improved

— 208

Form

# FIG. 8

16

Table-1
Methods of Arriving at Reduced Volume % $\gamma'$ Composition

| | | Elements % | | | | | | | | Volume % $\gamma'$ |
|---|---|---|---|---|---|---|---|---|---|---|
| | | Ni | Co | Cr | W | Ta | Ti | Al | Total % | 4(TA+Ti+Al) in At. % |
| PWA 1480 Original | Wt. % | 62.50 | 5.00 | 10.00 | 4.00 | 12.00 | 1.50 | 5.00 | 100.00 | |
| | At. % | 64.66 | 5.15 | 11.68 | 1.32 | 4.03 | 1.90 | 11.25 | 100.00 | 68.74 |
| | | Simple approach based on proportional reduction of (Ta+Ti=Al) | | | | | | | | |
| PWA 1480 (50% $\gamma'$) | At. % | 69.35 | 5.15 | 11.68 | 1.32 | 2.93 | 1.38 | 8.19 | 100.00 | 50 |
| | Wt. % | 67.37 | 5.03 | 10.05 | 4.02 | 8.77 | 1.10 | 3.66 | 100.00 | |
| | | Approach based on analyzed composition of $\gamma'$ and $\gamma$-matrix | | | | | | | | |
| PWA1480 Original Analyzed | At. % | 64.95 | 4.93 | 11.89 | 1.29 | 3.95 | 1.76 | 11.23 | 100.00 | 67.76 |
| $\gamma'$ Precipitate Analyzed | At. % | 72.33 | 2.73 | 1.94 | 0.89 | 5.19 | 2.52 | 14.4 | 100.00 | |
| $\gamma$-matrix Analyzed | At. % | 52.29 | 9.05 | 33.49 | 1.67 | 2.19 | 0.25 | 1.06 | 100.00 | |
| PWA 1480 (50% $\gamma'$) | At. % | 62.31 | 5.89 | 17.72 | 1.28 | 3.69 | 1.39 | 7.73 | 100.00 | 51.22 |
| | Wt. % | 59.92 | 5.69 | 15.09 | 3.86 | 10.94 | 1.09 | 3.42 | 100.00 | |

FIG. 9

**REFERENCES CITED IN THE DESCRIPTION**

**Patent documents cited in the description**

• US 20150284824 A